# FASCICULE DE BREVET EUROPEEN

(11) **EP 0 461 016 B1**
(45) Date de publication et mention de la délivrance du brevet: **23.08.1995**
(21) Numéro de dépôt: 91401435.2
(22) Date de dépôt: 03.06.1991
(51) Int. Cl.: H01L 39/24

(54) **Elément supraconducteur composite et son procédé de fabrication**
Supraleitendes zusammengesetztes Element und dessen Herstellungsverfahren
Superconducting composite element and its fabrication process

(30) Priorité: 05.06.1990 FR 9006927
(43) Date de publication de la demande: 11.12.1991
(73) Titulaire: COMMISSARIAT A L'ENERGIE ATOMIQUE, 75015 Paris (FR)
(72) Inventeur: Lambard, Jacques, F-94240 L'Hay les Roses (FR)
(74) Mandataire: Des Termes, Monique

(56) Documents cités:
- EP-A- 0 292 436
- EP-A- 0 364 946
- EP-A- 0 367 571
- JAPANESE JOURNAL OF APPLIED PHYSICS LETTERS vol. 28, no. 1, Janvier 1989,TOKYO, JP pages 82 - 84; HIKATA, T. ET AL: 'Ag-sheathed Bi-Pb-Sr-Ca-Cu-Osuperconducting wires with high critical current density'
- CRYOGENICS vol. 30, Mai 1990, LONDON, UKpages 430 - 433; OSAMURA K. ET AL: 'Dependence of critical current density onmicrostructure in Ag sheated Ba2YCu3O6+x tapes'

## Description

L'invention a pour objet un élément supraconducteur composite et son procédé de fabrication.

De façon plus précise, elle concerne la réalisation d'éléments supraconducteurs de forme allongée, tels que des fils ou des rubans, qui sont capables de conduire un courant électrique dans le sens de la longueur de l'élément, que l'on désignera ci-après "direction principale de l'élément".

Les matériaux supraconducteurs connus actuellement peuvent être utilisés en particulier dans deux types d'applications qui sont la métrologie où l'on n'exige que de faibles puissances, et le transport de courant qui exige au contraire de fortes puissances.

Pour les applications à fortes puissances, telles que les domaines du stockage de l'énergie, les alternateurs, les applications magnétiques, par exemple les aimants pour l'imagerie médicale(RMN), les accélérateurs de particules et le confinement pour la fusion nucléaire, il est nécessaire de disposer d'éléments supraconducteurs qui présentent, en dessous de leur température critique T_{c}, un état supraconducteur avec une densité de courant J inférieure à la densité de courant critique J_{c}. De plus, pour les applications magnétiques, le supraconducteur est soumis à un champ H inférieur au champ critique H_{c} pour obtenir l'annulation de la résistivité électrique de l'élément au-dessous de la densité de courant critique J_{c} et du champ critique H_{c}.

Pour ces applications à fortes puissances, il est donc important d'obtenir des valeurs aussi élevées que possible de J_{c} ou du couple J_{c} et H_{c}.

Parmi les matériaux supraconducteurs connus actuellement, les alliages métalliques tels que Nb-Ti ou Nb₃Sn répondent à ces exigences, mais ils doivent être refroidis à la température de l'hélium liquide, soit à 4,2K ou même plus bas, ce qui constitue un inconvénient.

En revanche, les nouveaux matériaux supraconducteurs tels que les oxydes mixtes de cuivre du type de celui découvert par Bednorz et Müller en 1986 peuvent fonctionner à des températures supérieures à celles de l'hélium liquide, en particulier au-dessus de la température de l'azote liquide, car leur température critique T_{c} est beaucoup plus élevée. Ainsi, pour la famille de matériaux supraconducteurs appartenant au type YBaCuO, Tc est de 93K, pour la famille de supraconducteurs du type BiSrCaCuO, Tc est de 80 à 110K, et pour la famille du type TlBaCaCuO, Tc est de 80 à 125K. Ceci est très avantageux, en raison de la différence de coût et de facilité de fonctionnement entre la température de l'hélium liquide, et celle de l'azote liquide, et pourrait conduire à des applications industrielles courantes des supraconducteurs.

De plus, ces supraconducteurs sont très intéressants pour des applications magnétiques car leurs champs critiques sont beaucoup plus élevés que ceux des composés intermétalliques du type Nb₃Sn.

Cependant, la réalisation d'éléments supraconducteurs tels que des filaments, des rubans ou des bandes, à partir de ces matériaux supraconducteurs de type céramique pose certains problèmes pour obtenir de forts courants critiques, réaliser un conducteur raisonnablement flexible et assurer la duratilité mécanique et chimique de l'élément.

En effet, les éléments conducteurs actuels réalisés à partir des matériaux supraconducteurs céramique tels que YBaCuO, sont formés de grains frittés et les propriétés de transport de ces conducteurs sont celles du fritté massif.

Avec ces conducteurs en matériau supracorducteur polycristallin fritté tel que YBaCuO, on peut obtenir des courants critiques de 1 à 10³A/cm², et généralement de l'ordre de 10²A/cm², ce qui est bien inférieur à ce que l'on devrait obtenir puisque les grains monocristallins de l'oxyde supracorducteur ont eux-mêmes des courants critiques beaucoup plus élevés. On suppose que ce phénomène provient d'une mauvaise liaison électrique entre les grains, mais les solutions proposées jusqu'à présent pour former des conducteurs de grandes dimensions n'ont pas donné entière satisfaction.

De même, il est difficile d'obtenir des fils flexibles à partir de ces matériaux céramique car après frittage on obtient une céramique fragile.

Enfin, la réactivité chimique des céramiques vis-à-vis des agressions externes exige de protéger efficacement ces éléments contre les agressions chimiques et les sollicitations exercées sur l'élément au cours de sa fabrication, de sa manipulation et de son emploi.

Les procédés connus actuellement pour réaliser des fils en matériau supraconducteur céramique font appel aux techniques d'extrusion ou de filage, comme il est décrit par D.W. Murphy et al dans Science, vol. 241, 1988, p. 922 à 930, mais ces techniques conduisent à l'obtention de courants critiques trop faibles, c'est-à-dire inférieurs à 2000A/cm² à 77K, qui chutent rapidement en présence de champs magnétiques. Pour remédier à cet inconvénient, on a envisagé d'utiliser des techniques de recristallisation pour obtenir une structure plus dense, mieux orienter les grains de matériau supraconducteur et améliorer ainsi les densités de courant critique, mais ces techniques sont difficiles à mettre en oeuvre pour réaliser des fils de grandes dimensions.

Un autre problème est la liaison entre les grains. L'augmentation du courant critique demande d'éliminer les impuretés au niveau du joint de grain, ,telles que les phases isolantes, semi-conductrices ou de matériau supraconducteur de plus basses températures critiques.

Ekin dans Advanced Ceramic Materials, vol. 2, n° 3B, 1987, p. 586-591 a étudié les différents moyens permettant d'améliorer les courants dans le matériau polycristallin, et il a indiqué que l'une des solutions serait d'orienter les cristallites pour que leurs plans de grandes conductibilités électriques soient parallèles dans le sens de la conduction du courant. Ceci pourrait être effectué par exemple en soumettant la poudre de YBaCuO à des forces électromagnétiques, avant frittage et traitement mécanique, pour obtenir une orientation préférentielle, mais aucune donnée expérimentale ne confirme cette amélioration.

On a envisagé également d'améliorer la densité le courant critique de matériaux supraconducteurs du type YBaCuO en leur ajoutant de l'argent comme il est indiqué par Plechacek et al dans Physica C 153-155 (1988), p. 878-879, mais les résultats obtenus montrent au contraire que la densité de courant critique décroît avec la teneur en argent.

On a aussi envisagé d'ajouter des métaux tels que l'argent, le cuivre et l'aluminium à des matériaux supraconducteurs du type YBaCuO pour pouvoir assurer plus facilement leur mise en forme, notamment pour des rubans, comme il est décrit par Prasad et al dans Materials Letters, vol. 7, n° 1,2, 1988, p. 9-12, mais ces auteurs ne précisent pas si l'adjonction d'un tel métal permet ou non d'améliorer la densité de courant critique.

Ainsi, aucun des procédés connus actuellement ne permet l'obtention d'éléments supraconducteurs de forme allongée, présentant de fortes densités de courant critique et de bonnes propriétés mécaniques.

La présente invention a précisément pour objet un élément composite supraconducteur de forme allongée tel qu'un fil, une bande ou un ruban, qui présente ces propriétés améliorées.

Selon l'invention, l'élément supraconducteur composite de forme allongée, capable de conduire un courant électrique selon une direction principale correspondant à la longueur de l'élément, comprend une âme en matériau supraconducteur composite comprenant un premier constituant contenant au moins une substance supraconductrice cristallisée, et un second constituant métallique formé d'au moins un métal ou alliage métallique, le premier constituant étant sous la forme de granules contenant au moins une rangée formée au moins d'un cristal d'une substance supraconductrice possédant un axe privilégié correspondant au plus grand côté de la maille cristalline, les rangées de cristaux présentant un axe privilégié couvrant la totalité de la longueur du granule et définissant ainsi la direction principale du granule, les granules étant agencés entre eux pour former au moins une rangée de sorte que leur direction principale détermine la direction principale de l'élément et les granules de chaque rangée étant réunis par des joints du second constituant métallique, dont l'épaisseur moyenne n'excède pas 15 fois la longueur de cohérence de ce deuxième constituant métallique/ et les axes privilégiés des cristaux de tous les granules formant une rangée selon la direction principale du granule et faisant sensiblement le même angle α avec la direction principale de l'élément pour tous les granules.

Dans l'élément supraconducteur composite décrit ci-dessus, la présence de joints du second constituant métallique d'épaisseur contrôlée entre les granules et l'orientation particulière des cristaux agencés en au moins une rangée selon la direction principale constituant les granules, permettent d'améliorer les liaisons entre cristaux et d'augmenter ainsi la densité de courant critique.

En effet, l'un des facteurs responsable de l'abaissement de la densité critique réside dans l'anisotropie du matériau par rapport au plan de base et dans le plan de base. Ainsi, dans le cas de YBaCuO, il existe pour chaque cristal un rapport d'environ 10 entre les conductibilités électriques dans le plan de base qui correspond aux plans CuO₂, et selon l'axe perpendiculaire qui correspond à la plus grande longueur de la maille de structure orthorhombique. Au niveau des joints de grains, avec des grains orientés au hasard, les plans CuO₂ de forte conductibilité sont désalignés et, de ce fait, une partie du courant doit transiter selon l'axe C de basse conductibilité électrique pour passer d'un cristal à un autre.

De même, lorsque les plans de base de deux cristaux voisins sont désorientés, ceci conduit à une diminution de la densité de courant critique.

Selon l'invention, on évite le premier phénomène d'anisotropie par rapport au plan de base étant donné que tous les axes privilégiés des cristaux font le même angle avec la direction principale de l'élément, l'axe privilégié pour ces cristaux anisotropes étant l'axe situé hors du plan de plus grande conductibilité électrique du cristal ou plan de base.

Selon un mode préférentiel de réalisation de l'invention, on évite aussi le second phénomène d'anisotropie, en agençant de plus les granules de façon que les axes privilégiés des cristaux de tous les granules soient parallèles à une direction fixe faisant un angle α avec la direction principale de l'élément. De la sorte, les plans de base des cristaux dans une rangée de granules sont parallèles les uns aux autres et il n'y a plus d'anisotropie dans le plan de base.

De même, la présence de joints métalliques d'épaisseur contrôlée entre les granules permet d'augmenter la densité de courant critique en diminuant les pertes au niveau des liaisons entre granules qui correspondent en l'absence de joints métalliques à des liaisons isolantes ou semi-conductrices.

Pour améliorer encore la liaison entre les grains par les joints du second constituant métallique, il est préférable selon l'invention, que les granules soient réunis entre eux par deux surfaces opposées parallèles faisant sensiblement le même angle α avec la direction principale aux axes privilégiés des cristaux.

Dans l'élément composite de l'invention, la substance supraconductrice utilisée peut être de différents types, elle est en particulier une substance supraconductrice cristalline qui présente une anisotropie sur la conductibilité électrique entre les 3 axes et pour laquelle il existe des problèmes de liens faibles entre les cristaux, par exemple une substance supraconductrice en céramique à base d'oxyde de cuivre telle que les céramiques du type YBaCuO, BiSrCaCuO, BiSrCaPbCuO ou TlBaCaCuO.

La céramique à base d'oxyde de cuivre peut répondre à la formule :

M¹M²Cu₃O₇_{-δ}

dans laquelle M¹ représente un ou plusieurs éléments des terres rares, y compris l'yttrium, M² représente un ou plusieurs métaux alcalinoterreux choisis parmi Sr, Ca et Ba, et δ est tel que

0≦δ≦0,4.

A titre d'exemple de telles céramiques, on peut citer les composés de formule :

La₂₋ₓSrₓCuO₄_{-δ} et YBa₂Cu₃O₇_{-δ}

L'invention s'applique en particulier à la substance supraconductrice de formule YBa₂Cu₃O₇_{-δ} avec δ compris entre 0 et 0,1.

Le second constituant métallique utilisé dans l'élément de l'invention est choisi parmi les métaux ou alliages pour lesquels le libre parcours moyen des électrons est aussi élevé que possible, à condition bien entendu que ces métaux ou alliages ne réagissent pas chimiquement avec la substance supraconductrice, dans les conditions de préparation ou d'utilisation de l'élément supraconducteur composite.

En effet, si l'on utilisait un métal susceptible de réagir avec la substance supraconductrice, ceci aurait pour effet de faire perdre aux joints, en tout ou partie, leurs propriétés de bonne conductibilité électrique, de transformer chimiquement la substance supraconductrice au niveau de l'interface, ou d'interposer dans le joint un film qui n'aurait pas de propriétés métalliques, par exemple un isolant ou un semiconducteur. Ceci se traduirait globalement par des augmentations de l'épaisseur de la liaison entre les granules ainsi que du libre parcours moyen des électrons dans la jonction.

Par ailleurs, il est important que la température de fusion du métal ou alliage utilisé n'excède pas de plus de 300°C la température de fusion de la substance supraconductrice.

De préférence, la température de fusion du métal ou alliage est inférieure à celle de la substance supraconductrice.

A titre d'exemple de métaux et d'alliages utilisables, on peut citer les métaux de transition, les métaux précieux, et les métaux à bas point de fusion tels que le cadmium, l'indium, l'étain, le plomb, et leurs alliages. Les métaux précieux peuvent être par exemple l'or, l'argent et leurs alliages.

Selon l'invention, on peut aussi utiliser comme second constituant métallique un métal ou un alliage supraconducteur, c'est-à-dire présentant un état supraconducteur à une température non nulle qui peut être bien entendu très inférieure à celle de la substance supraconductrice principale.

Lorsque l'on utilise comme second constituant métallique un métal ou un alliage supraconducteur, on choisit de préférence celui dont la constante de couplage entre les électrons est positive et aussi grande que possible, c'est-à-dire les métaux ou alliages ayant une température critique aussi élevée que possible. Un tel choix favorise en effet le transit des paires de Cooper dans le joint métallique grâce à l'effet de proximité, puisqu'on augmente globalement le potentiel de paires dans le joint métallique.

Selon une variante, le second constituant métallique peut comporter plusieurs métaux. Ceci est le cas en particulier lorsque les joints formés entre les granules sont composés de plusieurs couches métalliques de nature différente.

Dans ce cas, le métal ou l'alliage de la couche qui est en contact avec les granules, doit présenter les caractéristiques données ci-dessus, en particulier celle de ne pas réagir chimiquement avec la substance supraconductrice dans les conditions de préparation ou d'utilisation de l'élément supraconducteur. Le métal ou alliage formant les autres couches du joint quine seront pas en contact avec la substance supraconductrice, peut présenter des caractéristiques sensiblement différentes, notamment en ce qui concerne les points de fusion et la réactivité avec la substance supraconductrice, puisque le premier métal constitue une barrière chimique.

Les métaux ou alliages susceptibles de convenir comme second constituant métallique sont en particulier les métaux de transition et de préférence les métaux précieux.

Dans la structure de l'élément composite de l'invention, l'épaisseur des joints métalliques doit être contrôlée pour que l'on obtienne les propriétés voulues, notamment la densité de courant critique élevée.

En effet, la jonction entre les granules de la substance supraconductrice assure deux fonctions qui sont, d'une part, la liaison mécanique des granules les uns aux autres, et, d'autre part, la liaison électrique favorable au passage de forts supracourants dans le joint. Ces deux fonctions demandent si possible que la totalité des surfaces en regard des granules supraconducteurs soit engagée dans le joint. Obtenir de forts supracourants de jonction impose la réalisation de joints très minces, ce qui entraîne pour la tenue mécanique de soigner la qualité des plans de jonction des granules. Les joints métalliques ont une épaisseur moyenne limitée à 15 fois la longueur de cohérence effective du métal.

Des épaisseurs moyennes de joints susceptibles de convenir sont situées dans la gamme allant de 5 à 1000nm. De préférence, elles sont inférieures à 40nm lorsque l'élément supraconducteur est destiné à fonctionner à la température de l'azote liquide, et inférieures à 700nm lorsque l'élément est destiné à fonctionner à la température de l'hélium liquide.

De préférence, selon l'invention, l'élément supraconducteur comprend de plus un support ou une gaine métallique associé à au moins une rangée de granules qui constitue un circuit de conduction parallèle à celui du supraconducteur pour transporter le courant en cas de perte locale de la supraconductivité.

En effet, la rangée de granules peut être assimilée à une chaîne dont les maillons sont les grains, et la densité de courant maximale que peut transporter cette chaîne, est limitée à celle du plus faible des granules ou des jonctions entre granules sauf s'il existe un circuit parallèle plus efficace.

Le métal ou l'alliage constituant le support ou la gaine doit donc présenter les propriétés suivantes :
- une bonne conductibilité électrique,
- une compatibilité chimique avec la substance supraconductrice, et
- un coefficient de dilatation thermique proche de celui de la substance supraconductrice.

Dans le cas où la substance supraconductrice est un oxyde mixte à haute température critique, on peut utiliser par exemple les métaux précieux et leurs alliages, en particulier l'or et l'argent, et les métaux à bas point de fusion comme le cadmium, l'étain, l'indium et le plomb. Ces métaux présentent en effet l'avantage d'une mise en oeuvre à des températures non préjudiciables pour la substance supraconductrice.

On peut aussi utiliser un support ou une gaine formée de plusieurs couches superposées. Dans ce cas, la couche en contact avec la substance supraconductrice est constituée d'un des métaux ou alliages précédents, ayant la compatibilité chimique voulue avec la substance supraconductrice. Les autres couches quine sont pas en contact avec la substance supraconductrice, peuvent être réalisées en métal commun, par exemple en cuivre, en nickel et en leurs alliages ou en acier inoxydable.

De préférence, selon l'invention, les granules ont une épaisseur et une largeur à peu près constante. Par ailleurs, ils ont de préférence une faible épaisseur pour se présenter, par exemple sous la forme de plaquettes ou de lamelles. Dans ce cas, les plaquettes sont disposées de sorte que leur face de plus grande surface soit en appui sur le support. C'est le cas en particulier de granules obtenus par croissance de monocristaux car ces derniers croissent de sorte que leur épaisseur corresponde à l'axe privilégié.

Selon l'invention, l'élément composite peut comporter une seule rangée de granules ou plusieurs rangées de granules. Lorsque l'élément comporte plusieurs rangées de granules, celles-ci peuvent être juxtaposées dans l'une ou les deux directions perpendiculaires à la direction principale de l'élément en étant séparées les unes des autres par un support ou une gaine métallique.

On peut ainsi obtenir des structures juxtaposées ou superposées de rangées de granules, c'est-à-dire des structures du type multifilaments ou du type multicouches.

Dans tous les cas, l'élément supraconducteur formé d'une seule rangée ou de plusieurs rangées juxtaposées peut être entouré par une enveloppe externe assurant une protection électrique, mécanique et chimique. Cette enveloppe peut être réalisée en métal, par exemple en les mêmes métaux et alliages que précédemment.

On peut aussi utiliser une enveloppe non métallique dont le rôle sera limité à la protection mécanique et chimique de l'ensemble, par exemple une enveloppe en résine synthétique.

L'invention a également pour objet un procédé de préparation de l'élément composite supraconducteur décrit ci-dessus.

Ce procédé comprend les étapes suivantes :
a) préparer des granules de substance supraconductrice cristalline constitués par au moins une rangée formée d'au moins un cristal d'une substance supraconductrice possédant un axe privilégié correspondant au plus grand côté de la maille cristalline, les rangées de cristaux présentant un axe privilégié couvrant la totalité de la longueur du granule et définissant ainsi la direction principale du granule, et les axes privilégiés étant parallèles à un même plan ;
b) revêtir au moins deux faces opposées des granules, parallèles aux axes cristallographiques privilégiés des cristaux, avec un film comprenant au moins une couche de métal ou d'alliage métallique ;
c) assembler les granules entre eux de façon à former une rangée s'étendant selon la direction principale de l'élément dans laquelle les granules sont en contact par leurs faces opposées recouvertes du film métallique et dans laquelle les axes cristallographiques privilégiés de tous les cristaux font sensiblement le même angle avec la direction principale ; et
d) soumettre la rangée de granules à un traitement thermique pour réunir les granules entre eux par des joints métalliques formés à partir desdits films.

D'autres caractéristiques et avantages de l'invention apparaîtront mieux à la lecture de la description qui suit en référence aux dessins annexés.

La figure 1 est une vue en perspective du premier mode d'assemblage des granules de l'invention.

La figure 2 représente en coupe verticale l'un des granules de la figure 1 qui est formé de plusieurs cristaux.

La figure 3 est une vue en perspective du deuxième mode d'assemblage des granules de l'invention.

La figure 4 est une vue en perspective du troisième mode d'assemblage des granules de l'invention.

La figure 5 représente en perspective un granule de la figure 4.

La figure 6 est une courbe représentant les variations de la densité de courant critique d'éléments conformes à l'invention en fonction de l'épaisseur des joints métalliques.

La figure 7 illustre des courbes représentant les variations de la densité de courant critique d'éléments conformes à l'invention en fonction de la température (en K).

Dans la première étape du procédé de l'invention, on prépare des granules de substance supraconductrice constitués d'au moins un cristal.

Lorsque le granule comprend plusieurs cristaux, on prépare ces granules de façon que tous les cristaux du granule qui couvrent la longueur du granule selon la direction principale aient leur axe cristallographique, dit axe privilégié, parallèle à un même plan.

Ceci peut être obtenu par des procédés classiques faisant appel à des techniques de croissance cristalline telle que la transformation solide-solide, les croissances par fusion, la croissance en solution par fondant dans des conditions hydrothermiques, les croissances en phase vapeur par évaporation thermique, bombardement électronique ou ablation au laser, et les croissances en phase vapeur par les procédés de dépôt chimique en phase vapeur (CVD).

Lorsque le granule est constitué de plusieurs cristaux, on peut aussi utiliser les techniques de compression uniaxiale ou isostatique pour obtenir l'orientation voulue de l'axe privilégié de chaque cristal dans le granule.

Ainsi, dans le cas des supraconducteurs à structure bidimensionnelle, de type YBaCuO, les cristaux s'orientent lors de la compression uniaxiale, de façon à ce que l'axe perpendiculaire au plan de conduction des cristaux, qui est l'axe privilégié soit dans la direction de l'effort de compression.

On peut aussi obtenir l'orientation voulue des cristaux par action d'un champ magnétique, par exemple sur une poudre de la substance supraconductrice, suivie d'un frittage pour figer cette orientation.

Les moyens d'orientations magnétiques reposent sur une des propriétés des cristaux des supraconducteurs à haute température critique. L'alignement des cristaux est due à l'anisotropie de la susceptibilité magnétique des grains. Les grains ont tendance à s'aligner de sorte que la direction ayant la plus grande susceptibilité paramagnétique soit parallèle au champ magnétique appliqué.

L'alignement a été réalisé sur YBaCuO et HoBaCuO qui a été obtenu en remplaçant l'yttrium par l'holmium. L'holmium possède un moment paramagnétique effectif plus élevé que celui de l'yttrium, ce qui accroît la susceptibilité paramagnétique du composé.

Enfin, on peut utiliser les techniques de fabrication classique de monocristaux telles que la fusion de zone ou l'épitaxie pour obtenir des granules formés d'un seul cristal.

De préférence, selon l'invention, on prépare des granules dont une des dimensions est faible devant les deux autres pour obtenir des granules ayant la forme de plaquettes ou de lamelles dans lesquelles la surface de base correspond à un plan de conductibilité électrique préférentiel pour le granule. On peut aussi réaliser des granules cylindriques de faible diamètre et de hauteur plus importante. Dans le cas des céramiques à base d'oxyde de cuivre telles que les supraconducteurs du type YBaCuO, l'épaisseur des granules monocristallins est de préférence d'environ 0,01 à 0,1cm, les autres dimensions de la plaquette ou de la lamelle étant de l'ordre de 0,1 à 1cm.

Les granules obtenus ont une orientation précise, et sont constitués, par exemple dans le cas des supraconducteurs du type oxyde, par des lamelles dont le plan de conduction constitue la grande surface. La croissance de ces cristaux qui appartiennent à un des systèmes cristallographiques quadratique ou orthorhombique fait qu'ils se développent sous forme d'aiguilles ou de lamelles allongées. Les faces perpendiculaires au plan de la lamelle contiennent la direction privilégiée des cristaux.

Dans la deuxième étape du procédé de l'invention, on revêt au moins deux faces opposées des granules qui sont de préférence parallèles aux axes cristallographiques privilégiés des cristaux avec un film comprenant au moins une couche de métal ou d'alliage métallique, qui servira à réaliser les joints entre granules voisins dans l'élément composite.

Lorsque la plaquette a la forme d'un parallélépipède de faible hauteur, les faces à revêtir sont deux faces latérales opposées du parallélépipède, de préférence celles qui correspondent au plus petit côté du parallélogramme de base.

Le dépôt des couches de métal ou d'alliage métallique peut être effectué par des techniques classiques, par exemple des techniques physiques comme l'évaporation thermique, la pulvérisation cathodique, les techniques de dépôt où la cible est évaporée sous l'action d'une impulsion laser de haute énergie ou par bombardement électronique, ou des techniques chimiques comme les dépôts chimiques en phase vapeur, les dépôts chimiques du métal par déplacement ou encore l'usage de phases minérales ou organiques contenant le métal qui laisseront une couche de métal après un traitement chimique approprié.

Ces techniques de dépôt conviennent en effet car elles permettent de contrôler les épaisseurs déposées, par exemple par variation de la fréquence de résonance d'un quartz dans le cas des techniques en phase gazeuse, ou par contrôle des concentrations en sel du bain et des temps de dépôt pour les techniques de dépôt en solution.

Comme on l'a vu précédemment, l'épaisseur du dépôt doit être faible pour que les joints métalliques entre granules n'aient pas des épaisseurs trop importantes, ce qui nuirait à la liaison électrique entre granule.

De préférence, l'épaisseur du dépôt est limitée à 50nm, et de préférence encore dans le cas des supraconducteurs oxydes à haute'température critique, à quelques dizaines de couches atomiques de métal, qui est par exemple d'environ 3nm pour 10 couches.

Généralement, on réalise le dépôt à l'abri de l'oxygène pour empêcher la formation d'une couche d'oxyde sur le métal déposé. On opère par exemple sous gaz neutre comme l'argon. Toutefois, dans certains cas, on peut réaliser le dépôt en présence d'oxygène, notamment dans le cas des supraconducteurs YBaCuO où la présence d'oxygène favorise la stabilisation de propriétés supraconductrices.

Selon l'invention, on peut réaliser le dépôt, soit sur les deux faces de jonction du granule, soit sur la totalité de la surface externe des granules car ceci ne constitue pas un inconvénient et facilite plutôt la réalisation du dépôt, en particulier dans le cas des procédés chimiques et des techniques d'évaporation. Sur les régions quine servent pas à la jonction entre granules, des épaisseurs moindres ou supérieures de métal déposé n'ont pas d'incidence sur les caractéristiques de l'élément composite final.

Lorsque les films métalliques comportent plusieurs couches métalliques, on dépose successivement ces différentes couches en utilisant les techniques classiques mentionnées ci-dessus.

Après l'opération de revêtement des granules par le film comprenant au moins une couche de métal ou d'alliage métallique, on assemble les granules entre eux pour former une rangée de granules s'étendant selon la direction principale de l'élément.

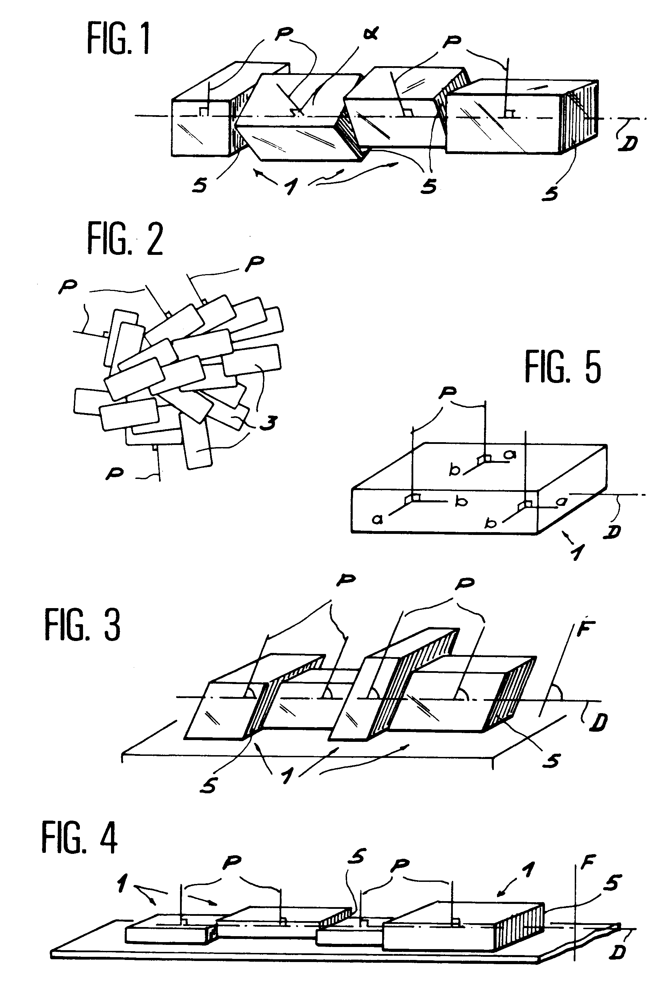

Sur les figures 1 à 5, on a représenté différents modes d'assemblage de ces granules.

Ainsi, la figure 1 représente en perspective un premier mode de réalisation de l'invention dans lequel on assemble des granules qui sont eux-mêmes constitués d'un assemblage de cristallites du matériau supraconducteur, de façon que les axes privilégiés des cristaux fassent sensiblement le même angle α avec la direction principale de l'élément, et restent ainsi parallèles à un même plan. Un cristallite est formé d'un cristal ou de plusieurs cristaux.

Sur cette figure 1, on voit que les granules 1 ont la forme de parallélépipèdes rectangles avec leurs axes privilégiés P perpendiculaires à la base du parallélépipède, et leurs faces latérales opposées 5 recouvertes d'un film de métal.

Dans ce cas, selon le premier mode de réalisation de l'invention, on assemble les granules 1 de façon telle que les axes privilégiés P des cristaux des granules forment le même angle α avec la direction principale D de l'élément, c'est-à-dire dans ce cas un angle de 90°.

Dans ce mode de réalisation, l'axe privilégié du cristal est perpendiculaire à ces deux autres axes cristallins, c'est le cas des matériaux supraconducterurs à hautes températures critiques, tels que les oxydes du type YBaCuO, BiSrCaCuO, BiSrCaPbCuO et TlBaCaCuO pour lesquelles l'axe privilégié du cristal est défini par le grand côté de la maille, noté c. Cet axe est perpendiculaire aux plans de conduction tels que CuO₂ définissant les deux autres longueurs de la maille a et b.

On précise que dans le cas où chaque granule est formé de plusieurs cristaux, les axes privilégiés des cristaux qui couvrent la totalité de la longueur du granule sont orientés dans chaque granule de façon à rester perpendiculaires à la direction principale de l'élément, en restant ainsi parallèles à un même plan.

Un tel amas de cristaux est illustré sur la figure 2 qui représente une coupe d'un granule 1 dans un plan perpendiculaire à la direction principale D de l'élément. Sur cette figure, on voit que tous les axes privilégiés P des cristaux 3 sont dans le plan de coupe du granule.

Dans ce premier mode de réalisation, les plans de conduction de chacun des cristaux seront seulement parallèles à la direction principale de l'élément. Dans ce cas, on s'intéresse aux jonctions d'extrémités entre les granules et non à la conductibilité entre les cristaux dans le plan de coupe de la figure 2. Ainsi, on peut accepter des phases parasites non supraconductrices entre les cristaux, à la condition que sur la longueur du granule dans le sens de la propagation du courant électrique, on assure la percolation des cristaux supraconducteurs. Cette disposition est intéressante car elle correspond à un mode de croissance de cristaux. La jonction entre granules est réalisée par des plans parallèles aux axes privilégiés des cristaux, c'est-à-dire des plans perpendiculaires à la direction principale de l'élément.

Selon un deuxième mode de réalisation de l'invention, l'assemblage des granules entre eux est tel que les axes privilégiés de tous les cristaux sont parallèles à une direction fixe.

La figure 3 représente un tel mode d'assemblage. Sur cette figure, on voit que les granules 1 ont la forme de parallélépipèdes obliques. Quand α est égal à 90°, il s'agit de cristaux du système cubique, quadratique ou orthorhombique. Quand α est différent de 90°, il s'agit de cristaux du système clinorhombique, rhomboédrique. Dans chacun des granules, les axes privilégiés P des cristaux font le même angle α avec la direction principale D de l'élément, en restant de plus parallèles à une direction fixe F qui fait le même angle α avec la direction D. Les granules n'ont pas nécessairement les mêmes dimensions, mais ils sont assemblés entre eux par deux faces opposées qui sont parallèles à un plan fixe faisant le même angle α avec la direction D.

Selon un troisième mode de réalisation de l'invention, l'assemblage des granules entre eux est tel que les axes privilégiés de tous les cristaux sont perpendiculaires à la direction principale de l'élément, tout en restant parallèles à une direction fixe.

La figure 4 représente un tel mode d'assemblage. Sur cette figure, on voit que les granules 1 ont la forme de parallélépipèdes rectangles avec les axes privilégiés P des cristaux perpendiculaires à la base du parallélépipède et à la direction principale D comme dans le premier mode de réalisation, mais dans ce cas, les axes privilégiés P sont de plus parallèles à la direction fixe F qui est également perpendiculaire à la direction principale D.

Dans ce mode d'assemblage, les jonctions entre granules sont effectuées par des faces perpendiculaires à la direction D.

Dans les différents modes de réalisation de l'invention, on peut orienter les cristaux dans chaque granule de façon que l'un des autres axes du cristal soit parallèle à la direction principale de l'élément.

La figure 5 représente en perspective un tel granule. Sur cette figure qui correspond au cas de YBaCuO, dans lequel l'axe privilégié P correspond au grand côté c de la maille cristallographique, a et b illustrent respectivement les deux autres longueurs de la maille cristallographique. On voit que l'un des axes a et b de chaque cristal élémentaire est parallèle à la direction principale D de l'élément.

Cette orientation est intéressante car elle correspond à un alignement des plans de conduction des cristaux. On peut encore améliorer les résultats en orientant les cristaux et les granules de façon que l'un des axes cristallins a ou b qui présente la meilleure conductibilité soit parallèle à la direction D, ce qui correspond au cas de granules constitués par des monocristaux.

On précise que, selon l'invention, on peut accepter certaines tolérances sur les angles entre les axes privilégiés et la direction principale, par exemple des différences de l'ordre de + 5°, et qu'il en est de même pour le parallélisme entre les axes privilégiés et la direction fixe ou le plan fixe, ou entre les faces de jonction des granules et le plan fixe, les défauts de parallélisme pouvant couvrir également la plage + 5°.

Dans la troisième étape du procédé de l'invention, on forme une rangée de granules s'étendant dais la direction principale de l'élément en disposant les granules à la suite l'un de l'autre de façon que leurs surfaces latérales revêtues du film de métal soient en contact les unes avec les autres en suivant l'un des modes d'assemblage décrits ci-dessus. L'orientation du granule peut être assurée facilement lorsqu'il se présente sous la forme de plaquettes d'épaisseur faible. On peut aussi obtenir cette préorientation sous l'action d'un champ magnétique à la température ambiante.

Dans la quatrième étape du procédé, on réalise les jonctions entre granules par frittage, par exemple en faisant passer l'assemblage de granules dans un four chauffé par effet Joule ou dans la boucle d'un four à haute fréquence. Ces opérations sont réalisées sous atmosphère contrôlée et l'atmosphère choisie dépend de la nature de la substance supraconductrice et du métal ou alliage constituant les films.

Dans le cas de films en argent ou en l'un de ses alliages et d'une substance supraconductrice du type YBaCuO, on peut utiliser une atmosphère contenant de l'oxygène car la température de fusion de l'argent est faible et la présence d'oxygène s'avère bénéfique pour l'oxyde supraconducteur. Toutefois, on préfère généralement opérer sous atmosphère de gaz neutre, par exemple d'argon ou d'hélium, afin d'empêcher l'oxydation superficielle du film métallique, notamment lorsqu'il s'agit de métaux oxydables et en particulier de métaux à bas point de fusion.

Après ce traitement, on obtient un élément supraconducteur constitué d'une rangée de granules réunis entre eux par des joints métalliques.

Généralement, on soumet l'élément à au moins une étape complémentaire de réalisation d'un support ou d'une gaine pour assurer une consolidation mécanique de l'ensemble et un circuit de conduction parallèle en cas de perte locale de la supraconductivité.

Dans le cas d'un support, celui-ci peut ne recouvrir qu'une face de la rangée de granules supraconducteurs.

Ce support peut être réalisé par des techniques classiques, par exemple par placage d'un film métallique ductile comme l'or ou l'argent, par dépôt d'un film épais de métal, par pulvérisation à la torche à plasma pour les métaux tels que l'or, l'argent ou les métaux à bas point de fusion, ou encore par des techniques utilisant un métal en fusion pour les métaux à bas point de fusion comme le cadmium, l'indium, l'étain, le plomb ou leurs alliages.

Dans le cas d'une gaine disposée tout autour de la rangée de granules, on peut utiliser les mêmes techniques de placage et de dépôt, notamment les techniques mettant en oeuvre un métal en fusion.

Après réalisation du support ou de la gaine, on peut assembler plusieurs rangées d'éléments entre elles, comme on l'a vu précédemment, pour former des éléments du type multifilaments, ou multicouches.

Selon l'invention, on peut également réaliser un traitement thermique complémentaire de stabilisation de l'élément pour relâcher les contraintes internes et permettre un éventuel rééquilibrage anionique du réseau de la substance supraconductrice. Les conditions de ce traitement dépendent en particulier de la substance supraconductrice et des métaux utilisés. Il peut être effectué, soit avant, soit après la réalisation du support ou de la gaine.

Dans certains cas, on complète ensuite l'élément par une enveloppe de protection externe, notamment lorsque le support ne recouvre qu'une partie de la surface externe de l'élément. Le rôle de cette enveloppe est d'assurer l'étanchéité et de protéger la substance supraconductrice contre les adversités dues à la manipulation et contre les agressions chimiques.

L'enveloppe externe peut être réalisée en résine synthétique obtenue par exemple par polymérisation sous rayonnement ultraviolet. Dans le cas où la ou les rangées de granules sont déjà recouvertes d'une gaine métallique, l'enveloppe peut être constituée par un tube de métal ou d'alliage. Les métaux utilisés peuvent être des métaux communs comme le cuivre, le nickel ou l'acier inoxydable.

On obtient ainsi en fin d'opération, un élément composite supraconducteur allongé possédant :
- une densité de courant élevée supérieure à celle des frittés, et éventuellement
- une flexibilité relative unidirectionnelle, et
- une protection électrique, mécanique et chimique efficaces de la substance supraconductrice.

Les exemples suivants, donnés bien entendu à titre non limitatif, illustrent la réalisation d'éléments supraconducteurs composites conformes à l'invention. Dans tous ces exemples, on utilise comme substance supraconductrice un oxyde mixte de cuivre de formule YBa₂Cu₃O₇_{-δ}.

### Exemple 1 : Préparation d'une poudre supraconductrice de YBa₂Cu₃O_{7-δ}.

Pour cette préparation, on part des poudres de haute pureté de Y₂O₃, BaCO₃ et CuO dans le rapport molaire 1/2, 2, 3. On broie et on mélange ces poudres, puis on introduit le mélange dans un creuset de platine que l'on porte à 900°C pendant 8h sous air pour obtenir la réaction entre les différents constituants. Le solide obtenu est rebroyé et subit de nouveau le même traitement thermique. On répète encore la réaction deux fois avec un chauffage de 950°C sous oxygène, les montées et descentes en température étant d'environ 100°C/h.

L'analyse par diffraction des rayons X du produit obtenu montre qu'il s'agit de la phase YBa₂Cu₃O₇_{-δ} de structure orthorhombique ayant pour constantes de réseau :
a=0,383nm
b=0,389nm, et
c=1,168nm.

Chaque grain de la poudre est polycristallin.

On vérifie que la poudre est supraconductrice à une température d'environ 90K en réalisant le test par mesure de la susceptibilité magnétique.

### Exemple 2.

Dans cet exemple, on prépare un élément supraconducteur composite à partir de la poudre obtenue dans l'exemple 1 en réalisant les joints métalliques en argent et en disposant les granules conformément au premier mode de réalisation de l'invention.

On comprime isostatiquement à froid la poudre de YBa₂Cu₃O₇_{-δ} ayant une granulométrie uniforme d'environ 20»m pour obtenir un granule ayant la forme d'un cylindre de révolution dont le diamètre est de 3mm et la longueur de 30mm, en appliquant une pression de 300MPa pendant 1 minute. On introduit ensuite le granule ainsi obtenu dans un tube d'acier inoxydable à paroi mince, on fait le vide dans le tube par pompage pendant 3h, on scelle celui-ci et on le comprime isostatiquement pendant 1h, à 800°C, au moyen d'argon, sous 200MPa. Lors de cette compression, les axes privilégiés des cristaux du granule s'orientent préférentiellement dans le plan normal au cylindre.

On refroidit ensuite en 3h à la température de 25°C puis on extrait le granule de son enveloppe.

On réalise plusieurs granules de cette façon, on soumet leurs faces d'extrémité perpendiculaires à l'axe du cylindre à une rectification, et on les recouvre d'un film d'argent d'une épaisseur de 50nm par évaporation sous vide du métal en fusion. On contrôle l'épaisseur du film par la fréquence de résonance d'un quartz.

Sur un granule cylindrique revêtu, ainsi préparé et tenu verticalement, on superpose les autres granules de façon que leurs faces d'extrémité revêtues du film d'argent soient en contact, puis on guide radialement l'assemblage dans un four balayé par un courant d'oxygène à la pression de 10⁵Pa.

Dans cet assemblage les axes privilégiés des cristaux restent perpendiculaires à la direction d'assemblage mais sont seulement parallèles à un plan fixe, comme représenté sur la figure 1.

On fait circuler l'assemblage dans le four et on chauffe le four de façon que la température de chaque granule croisse de 25 à 940°C à la vitesse de 300°C/h et que le temps de séjour d'un granule à la température maximale soit de 0,01 à 0,1h après quoi on refroidit jusqu'à 550°C à la vitesse de 20°C/h. On obtient ainsi un élément comprenant une rangée de granules réunis par des joints d'argent.

On réalise ensuite un support en argent sur une partie de la surface externe des granules en maintenant l'ensemble à 550°C, pendant 10h, et en le recouvrant latéralement par une couche d'argent, d'environ 0,5mm d'épaisseur, déposée par la technique de la torche à plasma. Selon cette technique, on introduit de la poudre d'argent dans la flamme chaude d'une torche à plasma et on projette des gouttes de métal fondu sur la surface latérale de l'élément qui se déplace en continu devant la torche à plasma. Après cette opération de revêtement et de traitement thermique simultané de stabilisation à 550°C sous oxygène, l'élément supraconducteur composite quitte le four à la vitesse de 300°C/h. On peut ainsi réaliser en continu un élément composite supraconducteur de grande longueur.

On vérifie ensuite que l'âme de l'élément supraconducteur composite correspond à YBa₂Cu₃O_{7-δ} polycristallin en mesurant la température critique de transition supraconductrice avec un courant de 0,1A. On trouve qu'elle est de 90K. La largeur de la transition est de 3K entre 10% et 90% de la hauteur de la transition. Les densités de courant critique sont d'environ 200 à 400A/cm².

### Exemple 3.

Cet exemple concerne la fabrication d'un élément composite supraconducteur dans lequel les granules sont assemblés par des joints d'argent conformément au second mode de réalisation de l'invention avec leurs axes privilégiés disposés perpendiculairement à la direction principale de l'élément.

On utilise la poudre de YBa₂Cu₃O₇_{-δ} préparée dans l'exemple 1, et on forme à partir de cette poudre, par compression uniaxiale sous 150MPa à 25°C, sans liant des granules parallélépipédiques ayant 3mm d'épaisseur, 3mm de largeur et 30mm de long. On dispose ensuite ces granules dans des nacelles allongées en zircone stabilisée avec 9% d'yttrium qui ont des dimensions intérieures correspondant à celles d'un granule, et on introduit les nacelles dans un four. On chauffe les granules dans le four balayé par un courant d'oxygène sous la pression de 10⁵Pa à une vitesse de 100°C/h. A 1300°C, l'oxyde mixte est liquide et on commence le processus de refroidissement et la croissance cristalline de YBaCuO.

Dans ce but, on maintient une des extrémités des nacelles à 1300°C et on refroidit l'autre extrémité à la vitesse de 1 à 50°C/h jusqu'à la température de 1100°C. A ce moment, on fait décroître la température du four en respectant ce gradient de 200°C jusqu'à ce que la température maximale de la nacelle soit de 700°C. Au-delà, la température du four chute de façon uniforme à 100°C/h jusqu'à 25°C.

Dans cette opération de fusion, le composé initial se décompose partiellement. Une partie cristallise sous forme d'aiguilles, ainsi désignées parce que les dimensions moyennes des cristaux sont, selon la vitesse de refroidissement, de 0,5 à 5mm de longueur et 0,01 à 0,1mm pour les dimensions transversales. Ces aiguilles correspondent à des empilements de cristaux de YBa₂Cu₃O₇_{-δ} pour lesquels il existe une direction commune. En effet, l'axe c est pour tous les cristaux du granule perpendiculaire à la direction longitudinale de l'aiguille. Une particularité intéressante de ces cristaux est, qu'à haute température, ils se développent sous la forme tétragonale YBa₂Cu₃O₇_{-δ} avec 0,5<δ<1, c'est-à-dire que les axes du plan de conduction (a et b) sont indifférenciés et que l'un correspond à la direction de l'aiguille. Au refroidissement, par suite de l'oxydation de la forme cristalline à haute température, l'axe correspondant à la direction privilégiée de l'aiguille sera a ou b (a≠b) et ceci dans une même aiguille cristal. La masse volumique des cristaux sous forme d'aiguilles est celle du matériau massif. Lors de la croissance cristalline, des régions de même forme cristalline qui correspondent à des aiguilles, se développent les unes à côté des autres en étant parfois séparées par des portions de substance non supraconductrice telle que Y₂BaCuO₅. Ces assemblages inhomogènes sont prélevés et constituent les granules de l'élément composite supraconducteur. On soumet les extrémités des granules à une coupe cristalline, puis on les recouvre d'un film d'argent, d'environ 20nm d'épaisseur, par évaporation thermique. On obtient ainsi des granules ayant une section transversale le 1 à 2mm et une longueur de 3 à 5mm.

On réalise alors l'assemblage de ces granules en les orientant magnétiquement. Dans ce but, on soumet chaque granule à un champ magnétique uniforme de 10kOe qui oriente les granules de manière que la direction longitudinale soit perpendiculaire aux lignes de champ. On guide alors radialement le granule pour qu'il vienne en contact par son extrémité inférieure avec l'extrémité supérieure du granule déjà en place.

On soumet ensuite l'assemblage ainsi obtenu à un traitement thermique à 940°C, sous oxygène, en faisant progresser l'élément dans un four à la vitesse de 200°C/h comme dans l'exemple 2.

Après cette opération, on dépose sur la surface externe de l'élément une couche d'argent de 0,2 à 0,4mm d'épaisseur par projection à la torche à plasma de poudre d'argent alors que l'élément est porté à une température de 500°C.

Après cette opération, on soumet l'élément à un recuit entre les températures de 500 et 400°C pendant 48h, puis on sort l'élément du four à la vitesse le 100°C/h.

L'élément obtenu a une densité de courant critique J_{c} d'environ 800A/cm².

### Exemple 4.

Dans cet exemple, on suit le même mode opératoire que dans l'exemple 3 pour préparer l'élément composite constitué de granules réunis par des joints d'argent. Dans ce cas, après le traitement thermique à 940°C sous oxygène, on réalise un recuit de l'élément entre les températures de 500 et 400°C pendant 48h, puis on dépose sur la surface de l'élément un revêtement d'indium de 0,5mm d'épaisseur par dépôt d'indium à 160°C.

La densité de courant critique de l'élément obtenu J_{c} est de 600A/cm².

### Exemple 5.

Dans cet exemple, on réalise un élément supraconducteur dans lequel des granules sont réunis par des joints d'argent et assemblés conformément au second mode de réalisation de l'invention représenté sur la figure 4.

On introduit dans une presse uniaxiale la poudre de YBaCuO d'une taille d'environ 10»m préparée dans l'exemple 1, et on lui fait subir sous air un traitement simultané de chauffage et de compression. On fait croître linéairement la pression jusqu'à 100MPa alors que la température s'élève de 25 à 700°C à la vitesse de 200°C/h. On maintient la pression pendant 3h à 700°C, puis pendant le refroidissement qui est réalisé à la vitesse de 200°C/h. On fritte ensuite le matériau pendant 8h à 950°C sous oxygène avec des mouvements de température du four de 300°C/h.

On obtient ainsi des granules ayant la forme de lamelles de 1mm d'épaisseur, 5mm de largeur et 15mm de longueur, qui sont constitués de céramique polycristalline monophasique YBa₂Cu₃O_{6,9} texturée avec des cristaux élémentaires ayant pour direction privilégiée l'axe de pressage. Les deux grandes faces correspondent au plan de pressage.

Dans ces granules la direction privilégiée donnée par l'axe c est perpendiculaire à la grande face de la lamelle, les autres axes cristallographiques parallèles à cette grande surface ont des orientations au hasard. La porosité des granules est de 15%.

On recouvre alors les faces latérales des granules qui correspondent aux deux plus petits côtés du rectangle de base d'un film d'argent d'une épaisseur de 50nm par évaporation thermique sous vide.

On assemble ensuite les granules entre eux par leurs extrémités recouvertes de film d'argent en s'assurant qu'il y ait recouvrement des deux faces en présence et que les faces de grande section restent parallèles deux à deux. On réalise ensuite le traitement thermique pour former les joints d'argent entre les granules comme dans l'exemple 2, puis on refroidit le four depuis 940°C jusqu'à 500°C à une vitesse de 300°C/h.

On soumet ensuite l'élément à un traitement de recuit sous oxygène à 500°C pendant 5h et on fait sortir l'élément supraconducteur du four à la vitesse de 300°C/h.

On réalise ensuite sur cet élément un dépôt d'argent de 0,5mm d'épaisseur formant support sur les deux plus grandes faces de l'élément en utilisant une torche à plasma comme dans l'exemple 2.

Un diagramme de diffraction des rayons X de l'élément ainsi obtenu montre que les granules de céramique polycristallins ont leur orientation avec l'axe privilégié c perpendiculaire au plan de conduction de l'élément supraconducteur et que le composé est la phase cristallisée YBa₂Cu₃O_{6,9}. La transition supraconductrice mesurée avec un courant le 0,1A sous champ nul est de 92K à mi-hauteur. La densité de courant critique est de 300A/cm² à 77K avec le critère de 1»V/cm. Cet élément ne présente pas de flexibilité.

### Exemple 6.

Dans cet exemple on utilise des granules constitués chacun par un seul cristal de YBaCuO et on les assemble par des joints en argent.

On réalise tout d'abord ces granules monocristallins par croissance cristalline à partir d'un bain dont la composition ne contient que les cations de la substance supraconductrice.

Les constituants Y, Ba et Cu sont pris en proportions molaires 3-27-70 sous la forme de perovskite supraconductrice YBa₂Cu₃O₇_{-δ} comme cela est décrit dans l'exemple 1 et sous la forme de BaCuO₂ et CuO.

Pour réaliser la croissance cristalline, on broie ces constituants, on les mélange et on forme à partir du mélange une pastille de 5g que l'on dispose dans une large coupelle plate en alliage platine'or. On chauffe la pastille à 970°C sous air à la vitesse de 100°C/h, on la maintient à cette température pendant 2h, puis on refroidit à 30°C/h entre 970 et 400°C.

A la température de 970°C, la présence de CuO et BaCuO₂ joue le rôle de flux qui permet d'abaisser la température de fusion du mélange. Des cristaux croissent librement à partir de la phase liquide qui se répand sur toute la surface de la coupelle. Les cristaux apparaissent sous forme libre et non enchâssés dans du matériau polycristallin, ils ont une forme bien marquée de parallélépipède rectangle avec un côté de faible croissance qui est parallèle à l'axe c de la structure. On obtient ainsi des cristaux extrêmement bien formés ayant des dimensions de 0,5x0,5x0,2mm³ environ. Sans traitement spécial de recuit sous oxygène, l'analyse par diffraction des rayons X montre que dans le plan de base du cristal, les axes a et b sont aléatoirement parallèles à l'un des côtés du cristal. Ces cristaux ou granules sont communément appelés cristaux simples bien qu'ils soient composés chacun de régions qui diffèrent entre elles par la disposition des axes a et b.

On réalise ensuite sur les faces latérales des granules de faible épaisseur un film d'argent ayant une épaisseur de 10 à 500nm par évaporation thermique.

On assemble ensuite les granules en les orientant magnétiquement dans un champ uniforme homogène de 10 teslas dont les lignes sont horizontales pour juxtaposer l'une contre l'autre leurs faces parallèles à l'axe c qui sont recouvertes d'argent.

Soumis à ce champ magnétique, les cristaux de YBaCuO s'aligent de manière que l'axe c soit parallèle au champ magnétique appliqué. Pour accroître la mobilité du granule soumis à ce champ magnétique, et faciliter son orientation, il est maintenu en lévitation au moyen d'un flux gazeux ascendant. Au fur et à mesure du positionnement d'un nouveau granule orienté dans le champ magnétique, l'édifice des granules est abaissé pour laisser l'entrefer de l'aimant libre pour l'orientation d'un nouveau granule.

On soumet ensuite l'ensemble à un traitement thermique pour réaliser les joints d'argent, sous une pression d'oxygène de 10⁵Pa, avec une vitesse de montée en température des granules de 200°C/h jusqu'à 940°C, puis une vitesse de descente de 200°C/h jusqu'à 500°C, un maintien de l'ensemble à cette température pendant 48h, puis un refroidissement à 200°C/h.

On réalise ensuite un recuit à 550°C sous oxygène pendant 10h.

La résistance de surface de l'argent des joints de l'élément supraconducteur mesurée par une méthode à deux contacts entre deux granules est d'environ 10⁻⁴ohms.cm². A 77K, la résistivité du joint d'argent est estimée à 10⁻⁶Ω.cm et le libre parcours moyen des électrons est de 100nm. La longueur de cohérence de l'argent à 77K est de 20nm. Le métal est donc propre. La densité de courant critique est mesurée par une méthode à 4 points par une technique d'impulsions. Avec une épaisseur de film de 10nm, soit une épaisseur de joint de 20nm, la densité de courant critique est supérieure à 10³A/cm².

Dans une première série d'essais, on effectue cette mesure sur des éléments ayant des épaisseurs de joints variant de 20 à 1000nm.

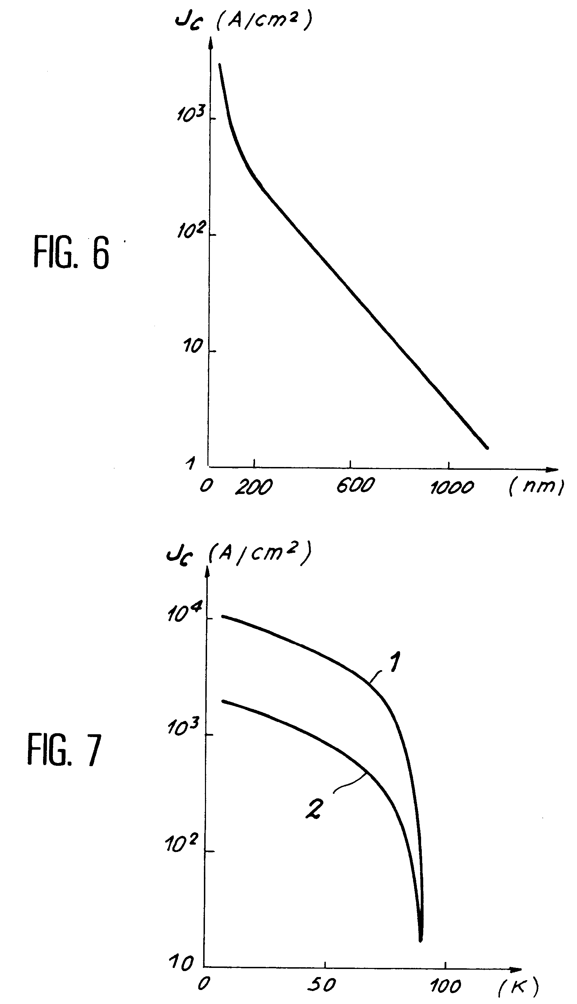

Sur la figure 6, on a représenté l'évolution de la densité de courant critique en fonction de l'épaisseur des joints métalliques. On remarque sur cette figure que la densité de courant critique croît rapidement lorsque l'épaisseur de joint diminue. Ainsi, à 77K, la densité de courant critique est de
- 2A/cm² pour 1000nm,
- 3.10²A/cm² pour 200nm
- 7.10²A/cm² pour 100nm, et environ
- 3.10³A/cm² pour 20nm.

L'augmentation de la densité de courant critique est ainsi plus forte pour les faibles épaisseurs de joints.

Dans une deuxième série d'essais, on mesure la densité de courant critique en fonction de la température, dans le cas d'éléments supraconducteurs composites ayant des épaisseurs de joint d'argent de 50nm et de 200nm. Les résultats obtenus sont donnés sur la figure 7 où la courbe 1 se réfère au cas de joints de 50nm d'épaisseur et la courbe 2 se réfère aux joints de 200nm d'épaisseur.

Comme on peut le voir sur cette figure, à 90K (température de transition), le courant est très faible.

A 77K, la densité de courant est de
- 3.10²A/cm² pour l'épaisseur de joint de 200nm,
- 1,5.10³A/cm² pour l'épaisseur de joint de 50nm.

A 4,2K, la densité de courant est de
- 2.10³A/cm² pour l'épaisseur de joint de 200nm
- 10⁴A/cm² pour l'épaisseur de joint de 50nm.

Ces résultats montrent donc qu'il est intéressant de limiter au maximum l'épaisseur des joints d'argent pour accroître la densité de courant critique.

L'élément composite décrit ci-dessus peut être complété par un enrobage complet par de l'indium. On utilise de l'indium maintenu à une température de 160°C et l'on forme tout autour de l'élément un revêtement d'indium d'une épaisseur de 0,5mm.

On réalise ensuite au-dessus du revêtement d'indium, une enveloppe en résine synthétique obtenue par polymérisation d'un film de résine époxy acrylate de 100»m d'épaisseur sous rayonnement ultraviolet.

On obtient ainsi un élément supraconducteur composite présentant une certaine souplesse. En effet, celui-ci peut être cintré dans le plan perpendiculaire à la face plane du composite avec un rayon de courbure de 10 à 20cm sans perdre ses propriétés supraconductrices.

La résistance à la flexion de cet élément est de 200-300MPa alors qu'elle n'est généralement que de 20 à 60MPa pour les fils de céramique polycristallin de l'art antérieur.

Ainsi, l'invention permet d'améliorer les propriétés mécaniques des éléments supraconducteurs.

### Exemple 7.

Dans cet exemple, on suit le même mode opératoire que dans l'exemple 6 pour préparer des granules monocristallins par croissance cristalline. On soumet les granules à un recuit sous 10⁵Pa d'oxygène pendant 48h à une température de 450°C, puis on dépose sur les faces latérales des granules un film métallique constitué d'une première couche d'or de 10nm d'épaisseur et d'une seconde couche de cadmium de 50nm d'épaisseur.

On réalise l'assemblage des granules comme dans l'exemple 6, puis on réalise la jonction entre les granules par transit dans un four à 320°C, en faisant augmenter la température des granules à la vitesse de 60°C/h et en la faisant descendre ensuite à la même vitesse. Après ce traitement, on dépose sur la totalité de la surface de l'élément un film d'indium de 0,5mm d'épaisseur comme dans l'exemple 6, puis on protège l'ensemble par une enveloppe synthétique comme dans l'exemple 6.

L'élément composite obtenu est supraconducteur à la température de 87K d'après des mesures de résistance par la méthode des 4 points à basse température. La densité de courant critique est de 400A/cm² à 77K, et de 3.10³A/cm² à 4,2K.

Cet élément peut être cintré sans dommage, si la courbure est réalisée sur le plan de conduction principal du composite. Le rayon de courbure est limité à 10-20cm.

## Revendications

1. Elément supraconducteur composite de forme allongée capable de conduire un courant électrique selon une direction principale correspondant à la longueur de l'élément, caractérisé en ce qu'il comprend une âme en matériau supraconducteur composite comprenant un premier constituant contenant au moins une substance supraconductrice cristallisée, et un second constituant métallique formé d'au moins un métal ou alliage métallique, le premier constituant étant sous la forme de granules contenant au moins une rangée formée au moins d'un cristal d'une substance supraconductrice possédant un axe privilégié correspondant au plus grand côté de la maille cristalline, les rangées de cristaux présentant un axe privilégié couvrant la totalité de la longueur du granule et définissant ainsi la direction principale du granule, les granules étant agencés entre eux pour former au moins une rangée de sorte que leur direction principale détermine la direction principale de l'élément et les granules de chaque rangée étant réunis par des joints du second constituant métallique, dont l'épaisseur moyenne n'excède pas 15 fois la longueur de cohérence de ce deuxième constituant métallique, et les axes privilégiés des cristaux de tous les granules formant une rangée selon la direction principale du granule et faisant sensiblement le même angle α avec la direction principale de l'élément pour tous les granules.

2. Elément selon la revendication 1, caractérisé en ce que les axes privilégiés des cristaux sont parallèles à une direction fixe faisant un angle α avec la direction principale de l'élément.

3. Elément selon l'une quelconque des revendications 1 et 2, caractérisé en ce que les granules sont réunis entre eux par deux surfaces opposées, faisant sensiblement le même angle avec la direction principale de l'élément.

4. Elément selon l'une quelconque des revendications 1 à 3, caractérisé en ce que l'axe privilégié de chaque cristal est perpendiculaire à la direction principale de l'élément.

5. Elément selon l'une quelconque des revendications 1 à 4, caractérisé en ce que la substance supraconductrice est une céramique.

6. Elément selon la revendication 5, caractérisé en ce que la céramique est YBa₂Cu₃O_{7-δ} avec δ tel que 0≦δ≦0,1, BiSrCaCuO ou TlBaCaCuO.

7. Elément selon l'une quelconque des revendications 1 à 6, caractérisé en ce que le second constituant est un métal choisi dans le groupe comprenant les métaux précieux, le cadmium, l'indium, l'étain, le plomb et leurs alliages ainsi que les métaux et alliages supraconducteurs.

8. Elément selon la revendication 7, caractérisé en ce que le métal précieux est l'or ou l'argent.

9. Elément selon l'une quelconque des revendications 1 à 8, caractérisé en ce que l'épaisseur moyenne des joints du second constituant est de 5 à 1000nm.

10. Elément supraconducteur selon l'une quelconque des revendications 1 à 9, caractérisé en ce qu'il comprend de plus un support métallique associé à chaque rangée de granules.

11. Elément supraconducteur selon l'une quelconque des revendications 1 à 9, caractérisé en ce qu'il comprend de plus une gaine métallique à l'intérieur de laquelle est disposée au moins une rangée de granules.

12. Elément selon l'une quelconque des revendications 10 et 11, caractérisé en ce que le métal du support ou de la gaine est choisi dans le groupe comprenant l'or, l'argent, le cadmium, l'étain, l'indium, le plomb et leurs alliages.

13. Elément selon l'une quelconque des revendications 10 et 11, caractérisé en ce que le support ou la gaine comprend au moins deux couches superposées, dont une première couche en contact avec la substance supraconductrice est réalisée en un métal choisi dans le groupe comprenant l'or, l'argent, le cadmium, l'étain, l'indium, le plomb et leurs alliages, et une seconde couche réalisée en métal choisi parmi le cuivre, le nickel, l'acier inoxydable et leurs alliages.

14. Elément selon l'une quelconque des revendications 11 à 13, caractérisé en ce qu'il comprend une enveloppe externe à l'intérieur de laquelle sont disposées la ou les rangées de granules.

15. Procédé de préparation d'un élément composite supraconducteur selon l'une quelconque des revendications 1 à 14, capable de conduire un courant électrique selon une direction principale, caractérisé en ce qu'il comprend les étapes suivantes :
a) préparer des granules de substance supraconductrice cristalline constitués par au moins une rangée formée d'au moins un cristal d'une substance supraconductrice possédant un axe privilégié correspondant au plus grand côté de la maille cristalline, les rangées de cristaux présentant un axe privilégié couvrant la totalité de la longueur du granule et définissant ainsi la direction principale du granule, et les axes privilégiés étant parallèles à un même plan ;
b) revêtir au moins deux faces opposées des granules, parallèles aux axes cristallographiques privilégiés des cristaux, avec un film comprenant au moins une couche de métal ou d'alliage métallique ;
c) assembler les granules entre eux de façon à former une rangée s'étendant selon la direction principale de l'élément dans laquelle les granules sont en contact par leurs faces opposées recouvertes du film métallique et dans laquelle les axes cristallographiques privilégiés de tous les cristaux font sensiblement le même angle avec la direction principale ; et
d) soumettre la rangée de granules à un traitement thermique pour réunir les granules entre eux par des joints métalliques formés à partir desdits films.

16. Procédé selon la revendication 15, caractérisé en ce que l'on soumet l'élément composite à un traitement thermique de stabilisation de la substance supraconductrice.

17. Procédé selon l'une quelconque des revendications 15 et 16, caractérisé en ce que l'on forme ensuite sur au moins une partie de la surface externe de la ou des rangées un revêtement comprenant au moins une couche de métal ou d'alliage et en ce que l'on protège ensuite l'ensemble par une enveloppe protectrice.

18. Procédé selon l'une quelconque des revendications 15 et 16, caractérisé en ce que l'on forme ensuite sur la totalité de la surface externe de chaque rangée une gaine comprenant au moins une couche de métal ou d'alliage.

19. Procédé selon la revendication 18, caractérisé en ce que l'on protège ensuite l'ensemble par une enveloppe de protection.

20. Procédé selon l'une quelconque des revendications 17 et 19, caractérisé en ce que l'enveloppe est en résine synthétique.

## Patentansprüche

1. Supraleitendes zusammengesetztes Element von länglicher Form, das einen elektrischen Strom in einer Hauptrichtung entsprechend der Länge des Elements leiten kann,
**dadurch gekennzeichnet**, daß es einen Kern aus supraleitendem zusammengesetztem Material aufweist, der einen ersten Bestandteil umfaßt, der wenigstens eine kristallisierte supraleitende Substanz enthält, und einen zweiten, metallischen Bestandteil, gebildet durch wenigstens ein Metall oder eine Metallegierung, wobei der erste Bestandteil die Form von Körnchen aufweist, die wenigstens eine Reihe aufweisen, gebildet durch wenigstens einen Kristall einer supraleitenden Substanz mit einer privilegierten Achse bzw. Vorzugsachse entsprechend der größeren Seite des Kristall-Gitters, die Kristall-Reihen eine Vorzugsachse über die Gesamtheit der Länge des Körnchens aufweisen und somit die Hauptrichtung des Körnchens definieren, die Körnchen so untereinander angeordnet sind, daß sie wenigstens eine Reihe bilden, damit ihre Hauptrichtung die Hauptrichtung des Elements bestimmt und die Körnchen von jeder Reihe verbunden sind durch Verbindungen bzw. Verbindungsstellen aus dem zweiten, metallischen Bestandteil, deren mittlere Dicke nicht fünfzehnmal die Kohärenzlänge dieses zweiten, metallischen Bestandteils überschreitet, und die Vorzugsachsen der Kristalle von allen Körnchen eine Reihe entsprechend der Hauptrichtung des Körnchens bilden und im wesentlichen denselben Winkel α mit der Hauptrichtung des Elements bilden, für alle Körnchen.

2. Element nach Anspruch 1, dadurch gekennzeichnet, daß die privilegierten Achsen bzw. Vorzugsachsen parallel sind zu einer festen Richtung, die mit der Hauptrichtung des Elements einen Winkel α bildet.

3. Element nach einem der Ansprüche 1 und 2, dadurch gekennzeichnet, daß die Körnchen miteinander verbunden sind durch zwei sich gegenüberstehende Flächen, die im wesentlichen denselben Winkel bilden mit der Hauptrichtung des Elements.

4. Element nach einem der Ansprüche 1 bis 3, dadurch gekennzeichnet, daß die Vorzugsachse jedes Kristalls senkrecht ist zur Hauptrichtung des Elements.

5. Element nach einem der Ansprüche 1 bis 4, dadurch gekennzeichnet, daß die supraleitende Substanz eine Keramik ist.

6. Element nach Anspruch 5, dadurch gekennzeichnet, daß die Keramik YBa₂Cu₃O₇₋δ mit δ z.B. 0≦δ≦0,1, BiSrCaCuO oder TlBaCaCuO ist.

7. Element nach einem der Ansprüche 1 bis 6, dadurch gekennzeichnet, daß der zweite Bestandteil ein Metall ist, das gewählt wird aus der Gruppe, die die Edelmetalle, das Cadmium, das Indium, das Zinn, das Blei und ihre Legierungen umfaßt, sowie die supraleitenden Metalle und Legierungen.

8. Element nach Anspruch 7, dadurch gekennzeichnet, daß das Edelmetall Gold oder Silber ist.

9. Element nach einem der Ansprüche 1 bis 8, dadurch gekennzeichnet, daß die mittlere Dicke der Verbindungen bzw. Verbindungsstellen des zweiten Bestandteils 5 bis 1000nm beträgt.

10. Element nach einem der Ansprüche 1 bis 9, dadurch gekennzeichnet, daß es außerdem einen jeder Körnchenreihe zugeordneten metallischen Träger umfaßt.

11. Element nach einem der Ansprüche 1 bis 9, dadurch gekennzeichnet, daß es außerdem eine metallische Hülle umfaßt, in deren Innern wenigstens eine Körnchenreihe angeordnet ist.

12. Element nach einem der Ansprüche 10 und 11, dadurch gekennzeichnet, daß das Metall des Trägers oder der Hülle gewählt wird aus der Gruppe, die Gold, Silber, Cadmium, Zinn, Indium, Blei und deren Legierungen umfaßt.

13. Element nach einem der Ansprüche 10 und 11, dadurch gekennzeichnet, daß der Träger oder die Hülle wenigstens zwei übereinanderliegende Schichten umfaßt, wovon eine erste Schicht, die Kontakt hat mit der supraleitenden Substanz, aus einem Metall hergestellt wird, das gewahlt wird aus der Gruppe, die Gold, Silber, Cadmium, Zinn, Indium, Blei und deren Legierungen umfaßt, und eine zweite Schicht aus Metall hergestellt wird, das ausgewählt wird unter Kupfer, Nickel, nichtoxidierbarem Stahl und deren Legierungen.

14. Element nach einem der Ansprüche 11 bis 13, dadurch gekennzeichnet, daß es eine Außenumhüllung umfaßt, in deren Innern die Körnchenreihe oder -reihen angeordnet sind.

15. Verfahren zur Vorbereitung eines supraleitenden zusammengesetzten Elements nach einem der Ansprüche 1 bis 14, das einen elektrischen Strom in einer Hauptrichtung leiten kann, dadurch gekennzeichnet, daß es die folgenden Schritte umfaßt:
a) Vorbereiten von Körnchen aus supraleitender kristalliner Substanz, gebildet durch wenigstens eine Reihe, bestehend aus wenigstens einem Kristall einer supraleitenden Substanz mit einer privilegierten Achse bzw. Vorzugsachse entsprechend der größeren Seite des Kristallgitters, wobei die Kristallreihen eine Vorzugsachse über die Gesamtheit der Länge des Körnchens aufweisen und somit die Hauptachse des Körnchens definieren und die Vorzugsachsen parallel zu ein und derselben Ebene sind;
b) Beschichten von wenigstens zwei entgegengesetzten, zu den kristallographisch privilegierten Achsen der Kristalle parallelen Flächen des Körnchens mit einem Film, der wenigstens eine Metall- der Metallegierungsschicht umfaßt;
c) Zusammensetzen der Körnchen untereinander, um eine Reihe zu bilden, die sich in einer Hauptrichtung des Elements erstreckt, in der die Körnchen durch ihre sich gegenüberstehenden, mit dem metallischen Film bedeckten Flächen in Kontakt sind und in der die privilegierten kristallographischen Achsen von allen Kristallen im wesentlichen den gleichen Winkel mit der Hauptrichtung bilden; und
d) Durchführen einer Wärmebehandlung der Körnchenreihe, um die Körnchen miteinander zu verbinden durch metallische Verbindungsstellen, gebildet durch besagte Filme.

16. Verfahren nach Anspruch 15, dadurch gekennzeichnet, daß man das zusammengesetzte Element einer Wärmebehandlung zur Stabilisierung der supraleitenden Substanz unterzieht.

17. Verfahren nach einem der Ansprüche 15 und 16, dadurch gekennzeichnet, daß man anschließend auf wenigstens einem Teil der Außenfläche der Reihe oder Reihen eine Verkleidung bildet, die wenigstens eine Metall- oder Legierungsschicht umfaßt, und dadurch, daß man anschließend das Ganze durch eine Schutzumhüllung schützt.

18. Verfahren nach einem der Ansprüche 15 und 16, dadurch gekennzeichnet, daß man anschließend auf der Gesamtheit der Außenfläche von jeder Reihe eine Hülle bildet, die wenigstens eine Metall- oder Legierungsschicht umfaßt.

19. Verfahren nach Anspruch 18, dadurch gekennzeichnet, daß man anschließend das Ganze durch eine Schutzumhüllung schützt.

20. Verfahren nach einem der Ansprüche 17 und 19, dadurch gekennzeichnet, daß die Umhüllung ein synthetisches Harz ist.

## Claims

1. Composite superconducting element of elongate shape capable of conducting an electric current in a principal direction corresponding to the length of the element, characterized in that it comprises a core made of composite superconducting material comprising a first constituent containing at least one crystallized super-conducting substance, and a metallic second constituent formed by at least one metal or metal alloy, the first constituent being in the form of granules containing at least one row formed by at least one crystal of a super-conducting substance possessing a preferred axis corresponding to the longest side of the crystal unit cell, the rows of crystals having a preferred axis covering the entire length of the granule and thus defining the principal direction of the granule, the granules being mutually organized in order to form at least one row so that their principal direction determines the principal direction of the element and the granules of each row being joined by joints of the metallic second constituent, the average thickness of which does not exceed 15 times the coherence length of this metallic second constituent, and the preferred axes of the crystals of all the granules forming a row along the principal direction of the granule and making substantially the same angle α with the principal direction of the element for all the granules.

2. Element according to Claim 1, characterized in that the preferred axes of the crystals are parallel to a fixed direction making an angle a with the principal direction of the element.

3. Element according to either of Claims 1 and 2, characterized in that the granules are joined together by two opposite surfaces, making substantially the same angle with the principal direction of the element.

4. Element according to any one of Claims 1 to 3, characterized in that the preferred axis of each crystal is perpendicular to the principal direction of the element.

5. Element according to any one of Claims 1 to 4, characterized in that the superconducting substance is a ceramic.

6. Element according to Claim 5, characterized in that the ceramic is YBa₂Cu₃O_{7-δ} with δ such that 0 ≦ δ ≦ 0.1, BiSrCaCuO or TlBaCaCuO.

7. Element according to any one of Claims 1 to 6, characterized in that the second constituent is a metal chosen from the group comprising the precious metals, cadmium, indium, tin, lead and their alloys, as well as the superconducting metals and alloys.

8. Element according to Claim 7, characterized in that the precious metal is gold or silver.

9. Element according to any one of Claims 1 to 8, characterized in that the average thickness of the joints of the second constituent is 5 to 1000 nm.

10. Superconducting element according to any one of Claims 1 to 9, characterized in that it additionally comprises a metallic support associated with each row of granules.

11. Superconducting element according to any one of Claims 1 to 9, characterized in that it additionally comprises a metallic sheath inside which at least one row of granules is arranged.

12. Element according to either one of Claims 10 and 11, characterized in that the metal of the support or of the sheath is chosen from the group comprising gold, silver, cadmium, tin, indium, lead and their alloys.

13. Element according to either one of Claims 10 and 11, characterized in that the support or the sheath comprises at least two superposed layers, a first layer of which, in contact with the superconducting substance, is made of a metal chosen from the group comprising gold, silver, cadmium, tin, indium, lead and their alloys, and a second layer made of metal chosen from copper, nickel, stainless steel and their alloys.

14. Element according to any one of Claims 11 to 13, characterized in that it comprises an external jacket inside which the row or rows of granules are arranged.

15. Process for preparing a superconducting composite element according to any one of Claims 1 to 14, capable of conducting an electric current in a principal direction, characterized in that it comprises the following steps:
a) preparing granules of a crystalline super-conducting substance which are constituted by at least one row formed by at least one crystal of a superconducting substance possessing a preferred axis corresponding to the longest side of the crystal unit cell, the rows of crystals having a preferred axis covering the entire length of the granule and thus defining the principal direction of the granule, and the preferred axes being parallel to the same plane;
b) coating at least two opposite faces of the granules, parallel to the preferred crystallographic axes of the crystals, with a film comprising at least one layer of metal or metal alloy;
c) assembling the granules together so as to form a row extending along the principal direction of the element, in which row the granules are in contact via their opposite faces covered with the metallic film and in which the preferred crystallographic axes of all the crystals make substantially the same angle with the principal direction; and
d) subjecting the row of granules to a heat treatment in order to join the granules together by metallic joints formed from the said films.

16. Process according to Claim 15, characterized in that the composite element is subjected to a heat treatment for stabilizing the superconducting substance.

17. Process according to either one of Claims 15 and 16, characterized in that a coating comprising at least one layer of metal or alloy is then formed on at least part of the external surface of the row or rows and in that the whole assembly is then protected by a protective jacket.

18. Process according to either one of Claims 15 and 16, characterized in that a sheath comprising at least one layer of metal or alloy is then formed over the entire external surface of each row.

19. Process according to Claim 18, characterized in that the whole assembly is then protected by a protective jacket.

20. Process according to either one of Claims 17 and 19, characterized in that the jacket is made of synthetic resin.
